# EUROPÄISCHE PATENTSCHRIFT

(11) **EP 0 619 386 B1**
(45) Veröffentlichungstag und Bekanntmachung des Hinweises auf die Patenterteilung: **17.06.1998**
(21) Anmeldenummer: 94250090.1
(22) Anmeldetag: 07.04.1994
(51) Int. Cl.: C25D 3/52, C25D 3/56

(54) **Elektrolytische Abscheidung von Palladium oder Palladiumlegierungen**
Electroplating of palladium or palladium alloys
Electrodéposition de palladium ou d'alliages de palladium

(30) Priorität: 07.04.1993 DE 4311983
(43) Veröffentlichungstag der Anmeldung: 12.10.1994
(73) Patentinhaber: ATOTECH Deutschland GmbH, 10553 Berlin (DE)
(72) Erfinder: Klein, Rudolf, D-12359 Berlin (DE); Rüther, Robert, Dr., D-13465 Berlin (DE)
(74) Vertreter: Effert, Udo, Dipl.-Ing.

(56) Entgegenhaltungen:
- DE-C- 3 307 174
- DATABASE WPI Week 7829, Derwent Publications Ltd., London, GB; AN 78-52895A & SU-A-572 539 (MINSK RADIO TECH) 4. September 1978

## Beschreibung

Die Erfindung betrifft eine Lösung zur elektrolytischen Abscheidung von Palladium oder Palladiumlegierungen, enthaltend vorzugsweise Palladiumsulfat und/oder -sulfamat und mindestens einen Komplexbildner für Palladiumionen. Die Erfindung betrifft ferner ein Verfahren zum elektrolytischen Beschichten elektrisch leitfähiger Substratoberflächen mit Palladium oder Palladiumlegierungen unter Verwendung dieser Lösung.

Galvanotechnische Verfahren werden seit langem zum Beschichten elektrisch leitfähiger Substratoberflächen mit Palladium oder dessen Legierungen für unterschiedliche Anwendungen, meist zu dekorativen Zwecken, eingesetzt. Beispielsweise können Palladiumschichten als Ersatz für die teureren Rhodiumschichten als dekorative Endschichten verwendet werden. Weiterhin dient Palladium auch als Ersatz für Nickelschichten, die als Diffusionssperre zwischen Gold oder Goldlegierungsschichten und einem Kupfer- oder Messingsubstrat dienen, beispielsweise auf Modeschmuck und Brillengestellen, da Nikkel allergische Reaktionen auf menschlicher Haut hervorrufen kann und daher gegen andere Metalle ersetzt werden muß.

Die Zusammensetzung elektrolytischer Palladium- und Palladiumlegierungsbäder ist in der Literatur bereits mehrfach beschrieben worden (R. J. Morrissey, Palladium- and Palladium-Nickel-Plating, Metal Finishing Guidebook (1988), 277-278). Danach kann Palladium aus Lösungen im neutralen, sauren und alkalischen pH-Bereich abgeschieden werden. Im neutralen und alkalischen pH-Bereich müssen die Palladiumverbindungen mit Komplexbildnern gegen Ausfällung von unlöslichen Palladiumverbindungen stabilisiert werden. Als Komplexbildner werden Amine, Phosphonsäuren und Hydroxyverbindungen angegeben. Weiterhin haben sich ebenfalls Ammoniak, Amidoschwefelsäure, Salze der schwefligen Säure sowie Ethylendiamin als geeignet erwiesen.

Die Lösungen enthalten, sofern Palladiumlegierungen abgeschieden werden, neben den Palladiumverbindungen auch die entsprechenden Metallverbindungen der weiteren Legierungskomponenten. Weiterhin enthalten die Lösungen Leitsalze und, um glänzende Palladiumschichten abscheiden zu können, organische Verbindungen als Glanzbildner.

In JP 63-111194 A wird eine Palladiumlösung zur elektrolytischen Abscheidung offenbart, die als organische Verbindung Pyridinsulfonsäure oder deren Alkalisalz enthält. Der pH-Wert dieser Lösung liegt zwischen 3,5 und 12.

In US-PS 4 673 472 werden Palladiumabscheidungslösungen mit einem pH-Wert von 1,5 bis 4, vorzugsweise von 2,0 bis 3,5, beschrieben. Diesen Lösungen werden heterocyclische organische Verbindungen als Glanzbildner, wie beispielsweise Succinimid, Maleimid, Pyridin und dessen Derivate, Nicotinsäure und dessen Derivate, Pyridiniumalkylsulfobetaine, Piperidin, Piperazin oder Pyrazin, zugegeben.

In EP-0 239 876 werden Palladiumabscheidungslösungen beschrieben, die Polyphosphat enthalten und Succinimid als glanzbildende Verbindung.

In DE-33 07 174 C2 wird ein galvanisches Palladiumbad beschrieben, das neben einem organischen Polyamin-Komplexbildner und einem cyclischen organischen Imid, wie beispielsweise Succinimid und Maleimid, Stickstoff enthaltende organische heterocyclische Verbindungen aus der Gruppe der Pyridinverbindungen, wie beispielsweise 2,2'-Bipyridyl und 4,4'-Bipyridyl, als Glanzbildner enthält. Der pH-Wert dieses Bades liegt im sauren und neutralen Bereich von 3 bis maximal 7.

In SU 572539 wird ein galvanisches Palladiumbad beschrieben, enthaltend Palladiumchlorid, Ammoniumsulfat, Saccarin, Harnstoff und 2,2'-Bipyridyl, zur Abscheidung harter und hochglänzender Überzüge, wobei Glanz und Härte wesentlich auf den Zusatz von Harnstoff und 2,2'-Bipyridyl zurückzuführen sind. Der pH-Wert dieses Bades liegt im Bereich von 6 bis 8.

Die bekannten Beschichtungslösungen enthalten zur Abscheidung glänzender Palladiumschichten neben den heterocyclischen Stickstoffverbindungen meist zusätzlich cyclische organische Imide, wie beispielsweise Succinimid. Bei Verwendung derartiger Verbindungen werden jedoch im allgemeinen keine bei derartigen Beschichtungen erwünschten hellglänzenden, sondern dunkle Palladiumschichten erhalten.

Einige der bekannten Palladiumbäder werden im sauren pH-Bereich eingesetzt. Bei diesen Bädern besteht daher die Gefahr, daß das saure Palladiumbad das Substrat während der Abscheidung anätzt und daß sich die aus Vorbehandlungsbädern in das Abscheidungsbad eingeschleppten Fremdionen, wie beispielsweise Eisen- und Kupferionen, negativ auf das Abscheidungsergebnis auswirken.

Ausgehend vom vor letztgenannten Stand der Technik liegt der vorliegenden Erfindung daher das Problem zugrunde, die Nachteile des Standes der Technik zu vermeiden und eine Lösung zur elektrolytischen Abscheidung von Palladium oder Palladiumlegierungen und ein Verfahren unter Anwendung einer derartigen Lösung zu finden.

Überraschenderweise gelöst wird das Problem durch die Patentansprüche 1 und 6. Bevorzugte Ausführungsformen der Erfindung sind in den Unteransprüchen angegeben.

Mit der erfindungsgemäßen Palladiumabscheidungslösung werden mehrere Vorteile gegenüber den bekannten Abscheidungslösungen erreicht: Es werden völlig schleierfreie, hochglänzende, helle Palladium- oder Palladiumlegierungsschichten abgeschieden. Die Schichten sind sehr duktil, so daß bei einem Test, bei dem das Substrat mit der darauf abgeschiedenen Schicht um 180° gebogen wird, keine Risse in der Schicht entstehen. Die Schichten platzen bei diesem Test auch nicht ab.

Ferner kann der pH-Wert der Lösung in einem Bereich von 5 bis 13,5, insbesondere auf einen pH-Wert größer oder gleich 8, eingestellt werden. Daher ist die Empfindlichkeit dieser Lösungen gegen die Einschleppung von Fremdionen, wie beispielsweise Eisen- oder Kupferionen, aus den Vorbehandlungsbädern außerordentlich gering. Die zu behandelnden Substrate bestehen im allgemeinen aus Metallen, beispielsweise Stahl, Kupfer oder Messing, die sich in den Bädern zur Vorbehandlung der Substrate vor der Palladiumbeschichtung durch oberflächlichen Ätzangriff der behandelten Substrate anreichern. Beim Überheben der Substrate von den Vorbehandlungsbädern werden diese Ionen in das Palladiumabscheidungsbad eingeschleppt. Da auch größere Mengen dieser Fremdionen die Palladiumabscheidung aus den erfindungsgemäßen Lösungen nicht beeinflussen, müssen die Substratoberflächen vor dem Eintauchen in das Palladiumabscheidungsbad nicht besonders aufwendig gespült werden.

Um die genannten Vorteile zu erreichen, werden der Lösung die aus einer großen Gruppe möglicher heterocyclischer Verbindungen identifizierten Verbindungen 2,3-Bis(2-pyridyl)-pyrazin, 2,2'-Bichinolyl, 2,4'-Bipyridyl, 1,10-Phenanthrolin oder 4,4'-Dicarboxyl-2,2' -bichinolyl oder deren Gemische zugegeben. Besonders gut geeignet ist 2,3-Bis(2-pyridyl)-pyrazin, das in einem Testprogramm zufällig aufgefunden und dessen hervorragende Wirkung festgestellt wurde. Aus Palladiumlösungen, die mindestens eine dieser Verbindungen enthalten, können hochglänzende und helle Schichten abgeschieden werden. Ferner können den Lösungen zusätzlich die Verbindungen 2,2'-Bipyridyl und/oder 4,4'-Bipyridyl zugegeben werden, um die glanzbildende Wirkung zu steigern.

Die genannten Verbindungen weisen eine Ferroin-, Cuproinstruktur bzw. stellungsisomere Strukturen dieser Typen auf:

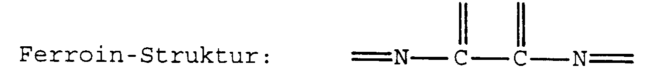

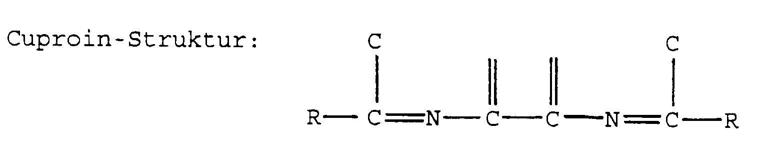

Die Verbindungen 2,3-Bis (2-pyridyl)-pyrazin, 2,4'-Bipyridyl, 1,10-Phenanthrolin, 2,2'-Bipyridyl und 4,4'-Bipyridyl gehören dem Ferrointyp, 2,2'-Bichinolyl und 4,4'-Dicarboxyl-2,2'-bichinolyl dem Cuprointyp an.

Die Verbindungen werden vorzugsweise in Konzentrationen von 3 bis 80 mg/l Lösung eingesetzt. Um die gewünschten Eigenschaften der abgeschiedenen Schichten zu erhalten, ist es nicht erforderlich, der Palladiumabscheidungslösung andere als die genannten heterocyclischen Verbindungen als Glanzbildner zuzugeben. Insbesondere ist der Zusatz cyclischer Imide, wie beispielsweise Succinimid oder Maleimid, nicht erforderlich. Daher können auch sehr helle Schichten abgeschieden werden. Die Glanzwirkung der genannten Verbindungen erstreckt sich auf einen sehr breiten Stromdichtebereich. Es hat sich ferner gezeigt, daß der gleichzeitige Einsatz mehrerer Verbindungen zu einem verbesserten Ergebnis führt. Beispielsweise kann die Glanzwirkung von 2,2'-Bichinolyl enthaltenden Abscheidungslösungen gesteigert werden, wenn der Lösung zusätzlich die heterocyclische Verbindung 2,2'-Bipyridyl zugesetzt wird. Durch Zusatz dieser Verbindung wird dabei die Glanzwirkung in einem Umfange gesteigert, der mit einer dem Zusatz von 2,2'-Bipyridyl entsprechenden erhöhten Menge von 2,2'-Bichinolyl nicht erreicht werden könnte.

Als Palladiumverbindungen enthalten die Abscheidungslösungen vorzugsweise anorganische Palladiumsalze. Besonders gut geeignet sind Palladiumsulfat und -sulfamat. Ferner sind auch die Chloride, Nitrate, Nitrite, Phosphate sowie deren Komplexsalze mit Ammoniak verwendbar.

Weiterhin enthalten die Lösungen Leitsalze, wie beispielsweise die Salze der Phosphorsäure und/oder Amidoschwefelsäure. Die Salze der Phosphorsäure dienen in diesen Lösungen unter anderem als Komplexbildner für Palladiumionen. Da den Lösungen keine Chelat-Komplexbildner, wie organische Polyamine oder EDTA, zugegeben werden müssen, sind keine aufwendigen Maßnahmen für die Abwasserentsorgung dieser Lösungen erforderlich. Die Lösungen können auch Ammoniak und/oder Ammoniumsalze als Komplexbildner enthalten.

Der pH-Wert dieser Lösungen wird auf einen Wert von 5 bis 13,5, insbesondere auf einen pH-Wert größer oder gleich 8, eingestellt.

Falls Legierungsschichten von Palladium abgeschieden werden sollen, werden die Legierungsmetalle der Abscheidungslösung als geeignete Metallverbindungen zugegeben. Gegebenenfalls enthält die Abscheidungslösung in diesem Fall weitere geeignete Komplexbildner für die Verbindungen der Legierungsmetalle. Als Legierungsmetalle können Silber, Nickel, Kupfer, Kobalt, Gold, Chrom, Zinn, Indium, Ruthenium, Rhodium, Platin, Iridium und Wismut zusammen mit Palladium abgeschieden werden.

Die Palladiumabscheidungslösung kann ferner weitere Stoffe enthalten, wie beispielsweise Netzmittel, Säure und Basen.

Die Palladiumschichten werden auf den Substratoberflächen elektrolytisch abgeschieden, indem diese mit der Abscheidungslösung in Kontakt gebracht und gegenüber einer oder mehrerer elektrisch leitfähiger Elektrodenoberflächen, die ebenfalls mit der Abscheidungslösung in Kontakt stehen, kathodisch polarisiert werden. Hierzu wird zwischen den zu beschichtenden Substratoberflächen und den Elektrodenoberflächen ein Stromfluß erzeugt. Die Schichten werden bei Stromdichten zwischen 0,1 und 400 A/dm² abgeschieden. Die Schichten können mit Stromdichten im oberen Bereich abgeschieden werden, wenn die Abscheidungslösung mit hoher Geschwindigkeit auf die Substratoberflächen gepumpt wird. Als Elektrodenmaterial kann Graphit, Edelstahl oder Titan eingesetzt werden. Bevorzugt werden platinierte Metalle als Elektroden verwendet.

Die Palladiumabscheidungslösung wird vorzugsweise zur Beschichtung von Substraten zu dekorativen Zwecken, beispielsweise für die Beschichtung von Modeschmuck, Brillengestellen und Uhrengehäusen, eingesetzt. Hierbei dient die Palladiumschicht entweder als dekorative Endschicht oder als Diffusionssperre zwischen einem Kupfer enthaltenden Substrat und einer Goldschicht. Ferner können die Palladiumschichten auch in der Leiterplattentechnik anstelle der üblicherweise verwendeten Nickelschichten als Diffusionssperre zwischen Gold und Kupfer verwendet werden.

Die folgenden Beispiele sollen die Erfindung näher erläutern.

### Beispiel 1:

Es wurde folgende wäßrige Lösung zur elektrolytischen Palladiumabscheidung angesetzt:

| | |
|---|---|
| Palladium als Palladiumsulfat | 7 g/Liter, |
| Diammoniumhydrogenphosphat | 75 g/Liter, |
| 2,3-Bis(2-pyridyl)-pyrazin | 20 mg/Liter, |

Die Lösung wurde mit Ammoniaklösung auf einen pH-Wert von 8 eingestellt. In dieser Lösung wurde ein zweifach um einen Winkel von jeweils etwa 90 ° gebogenes Blech aus vernickeltem Messing 3 Minuten bei einer Stromdichte von 1 A/dm² und einer Temperatur von 55 °C mit Palladium beschichtet. Als Anoden dienten zwei platinierte Titanbleche.

Es wurde eine spiegelglänzende, schleierfreie und duktile Palladiumschicht erhalten.

### Beispiele 2 bis 5:

Beispiel 1 wurde mit den Verbindungen 2,2'-Bichinolyl, 1,10-Phenanthrolin, 2,4'-Bipyridyl und 4,4'-Dicarboxyl-2,2'-bichinolyl anstelle von 2,3-Bis(2-pyridyl)-pyrazin wiederholt. Die Verbindungen wurden in einer Konzentation von 30 mg/Liter Lösung eingesetzt. Es wurden wie in Beispiel 1 spiegelglänzende, schleierfreie und duktile Palladiumschichten erhalten.

### Beispiel 6:

Es wurde eine wäßrige Lösung zur elektrolytischen Palladiumabscheidung mit der folgenden Zusammensetzung angesetzt:

| | |
|---|---|
| Palladium als Palladiumsulfat | 7 g/Liter |
| Diammoniumhydrogenphosphat | 75 g/Liter |
| 4,4'-Dicarboxyl-2,2'-bichinolyl | 40 mg/Liter |
| 2,2'-Bipyridyl | 30 mg/Liter |

Die Lösung wurde mit Ammoniaklösung auf einen pH-Wert von 8 eingestellt. Unter den in Beispiel 1 angegebenen Bedingungen wurde eine sehr helle, spiegelglänzende Palladiumschicht erhalten.

### Beispiel 7:

Beispiel 6 wurde mit einer Glanzbildner-Kombination aus 2,3-Bis(2-pyridyl)-pyrazin und 2,4'-Bipyridyl anstelle der Kombination aus 4,4'-Dicarboxyl-2,2' -bichinolyl und 2,2'-Bipyridyl wiederholt. 2,3-Bis(2-pyridyl)-pyrazin wurde in einer Konzentration von 40 mg/Liter Lösung und 2,4'-Bipyridyl in einer Konzentration von 20 mg/Liter Lösung eingesetzt.

Es wurden ebenso wie in Beispiel 6 helle, spiegelglänzende Palladiumschichten erhalten.

### Beispiel 8:

Es wurde folgende wäßrige Palladiumabscheidungslösung angesetzt:

| | |
|---|---|
| Palladium als Pd(NH₃)₄Cl₂ | 4,5 g/Liter |
| Kaliumsulfamat | 50 g/Liter |
| 2,3-Bis(2-pyridyl)-pyrazin | 30 mg/Liter |

Die Lösung wurde mit Ammoniaklösung auf einen pH-Wert von 9 eingestellt. Die Abscheidung wurde mit Graphitanoden durchgeführt. Bei einer Stromdichte von 0,5 A/dm² und innerhalb von 2 Minuten wurde eine glänzende, duktile Palladiumschicht erhalten.

### Beispiel 9:

Es wurde folgende wäßrige Lösung zur Abscheidung einer Palladium/Zinn-Legierung angesetzt:

| | |
|---|---|
| Palladium als Palladiumsulfat | 7,5 g/Liter |
| Diammoniumhydrogenphosphat | 50 g/Liter |
| 4,4'-Dicarboxyl-2,2'-bichinolyl | 20 mg/Liter |
| 4,4'-Bipyridyl | 30 mg/Liter |
| Zinn als K₂Sn(OH)₆ | 1 g/Liter |

Die Lösung wurde mit Ammoniaklösung auf einen pH-Wert von 8 eingestellt. Unter den in Beispiel 1 angegebenen Bedingungen wurde eine sehr helle, spiegelglänzende Palladium/Zinn-Legierungsschicht erhalten.

## Patentansprüche

1. Lösung zur elektrolytischen Abscheidung von Palladium oder Palladiumlegierungen, enthaltend vorzugsweise Palladiumsulfat und/oder sulfamat und mindestens einen Komplexbildner für Palladiumionen, wobei in der Lösung zusätzlich mindestens eine heterocyclische Verbindung, ausgewählt aus der Gruppe 2,3-Bis(2-pyridyl)-pyrazin, 2,2'-Bichinolyl, 2,4'-Bipyridyl, 1,10-Phenanthrolin und 4,4'-Dicarboxyl-2,2'-bichinolyl, enthalten ist.

2. Lösung nach Anspruch 1, dadurch gekennzeichnet, daß in der Lösung zusätzlich 2,2'-Bipyridyl und/oder 4,4'-Bipyridyl enthalten sind.

3. Lösung nach einem der vorstehenden Ansprüche, dadurch gekennzeichnet, daß die heterocyclischen Verbindungen in Konzentrationen von jeweils 3 bis 80 mg/l Lösung enthalten sind.

4. Lösung nach einem der vorstehenden Ansprüche, gekennzeichnet durch einen pH-Wert von 5 bis 13,5.

5. Lösung nach einem der vorstehenden Ansprüche, dadurch gekennzeichnet, daß die Lösung Salze der Phosphorsäure, Amidoschwefelsäure, Ammoniak und/oder Ammoniumsalze als Komplexbildner enthält.

6. Verfahren zum elektrolytischen Beschichten elektrisch leitfähiger Substratoberflächen mit Palladium oder Palladiumlegierungen mit den Verfahrensschritten:
a. In-Kontakt-Bringen der Substratoberflächen und mindestens einer vorzugsweise platinierten elektrisch leitfähigen Elektrodenoberfläche mit einer Lösung mit einem pH-Wert von 5 bis 13,5, vorzugsweise mit einem pH-Wert größer oder gleich 8, enthaltend mindestens eine Palladiumverbindung, vorzugsweise Palladiumsulfat und/oder Palladiumsulfamat, mindestens einen Komplexbildner für Palladiumionen und mindestens eine heterocyclische Verbindung, ausgewählt aus der Gruppe 2,3-Bis(2-pyridyl)-pyrazin, 2,2'-Bichinolyl, 1,10-Phenanthrolin, 4,4'-Dicarboxyl-2,2'-bichinolyl, 2,4'-Bipyridyl, und
b. Erzeugen eines Stromflusses zwischen den Substratoberflächen und den Elektrodenoberflächen, wobei die Substratoberflächen als Kathode und die Elektrodenoberflächen als Anode polarisiert werden.

## Claims

1. Solution for the electrolytic deposition of palladium or palladium alloys, preferably containing palladium sulphate and/or sulphamate and at least one complexing agent for palladium ions, wherein at least one heterocyclic compound, selected from the group 2,3-bis(2-pyridyl)-pyrazine, 2,2'-bichinolyl, 2,4'-bipyridyl, 1,10-phenanthroline and 4,4'-dicarboxyl-2,2'-bichinolyl, is additionally contained in the solution.

2. Solution according to claim 1, characterised in that 2,2'-bipyridyl and/or 4,4'-bipyridyl are additionally contained in the solution.

3. Solution according to one of the preceding claims, characterised in that the heterocyclic compounds are each contained in concentrations of from 3 to 80 mg/l solution.

4. Solution according to one of the preceding claims, characterised by a pH value from 5 to 13.5.

5. Solution according to one of the preceding claims, characterised in that the solution contains salts of phosphoric acid, amidosulphunc acid, ammonia and/or ammonium salts as the complexing agent.

6. Method for the electrolytic coating of electrically conductive substrate surfaces with palladium or palladium alloys, having the method steps:
a. bringing into contact the substrate surfaces and at least one preferably platinum-plated, electrically conductive electrode surface with a solution having a pH value from 5 to 13.5, preferably having a pH value greater than or equal to 8, containing at least one palladium compound, preferably palladium sulphate and/or palladium sulphamate, at least one complexing agent for palladium ions and at least one heterocyclic compound, selected from the group 2,3-bis(2-pyridyl)-pyrazine, 2,2'-bichinolyl, 1,10-phenanthroline, 4,4'-dicarboxyl-2,2'-bichinolyl, 2,4'-bipyridyl, and
b. producing a flow of current between the substrate surfaces and the electrode surfaces, the substrate surfaces being polarised as the cathode, and the electrode surfaces being polarised as the anode.

## Revendications

1. Solution de dépôt électrolytique de palladium ou d'alliages de palladium, contenant de préférence du sulfate de palladium et/ou du sulfamate de palladium et au minimum un agent complexant des ions palladium, solution qui renferme en plus au moins un composé hétérocyclique choisi dans le groupe 2,3-bis(2-pyridyl)-pyrazine, 2,2'-biquinoléine, 2,4'-bipyridyle, 1,10-phénanthroline et 4,4'-dicarboxyl-2,2'-biquinoléine.

2. Solution selon la revendication 1, caractérisée en ce qu'elle renferme en plus du 2,2'-bipyridyle et/ou du 4,4'-bipyridyle.

3. Solution selon l'une des revendications 1 et 2, caractérisée en ce qu'elle contient des composés hétérocycliques ayant respectivement une concentration comprise entre 3 et 80 mg/l de solution.

4. Solution selon l'une quelconque des revendications 1 à 3, caractérisée en ce que son pH est compris entre 5 et 13,5.

5. Solution selon l'une quelconque des revendications 1 à 4, caractérisée en ce qu'elle contient, en tant qu'agent complexant, des sels d'acide phosphorique, des sels de l'acide amidosulfurique, de l'ammoniaque et/ou des sels d'ammonium.

6. Procédé pour le revêtement par électrolyse des surfaces de substrat conductrices avec du palladium ou des alliages de palladium selon les étapes suivantes :
a. mettre en contact la surface de substrat et au moins une surface de l'électrode de préférence enduite de platine et conductrice avec une solution ayant un pH compris de 5 à 13,5, de préférence avec un pH supérieur ou égal à 8, contenant au moins un composé de palladium, de préférence du sulfate de palladium et/ou du sulfamate de palladium, au moins un agent complexant des ions de palladium et au moins un composé hétérocyclique choisi dans le groupe 2,3-bis(2-pyridyl)-pyrazine, 2,2'-biquinoléine, 1,10-phénanthroline, 4,4'-dicarboxyl-2,2'-biquinoléine, 2,4'-bipyndyle, et
b. produire un courant entre la surface du substrat et la surface de l'électrode, ce qui a pour conséquence que la surface du substrat sera polarisée en tant que cathode et la surface de l'électrode sera polarisée en tant qu'anode.
